Europäisches Patentamt

European Patent Office

Office européen des brevets

(19)

(11) Publication number: 0 273 227
A2

# (12) EUROPEAN PATENT APPLICATION

(21) Application number: 87117841.4

(22) Date of filing: 02.12.87

(51) Int. Cl.⁴: H05K 3/38 , C25D 5/50

(30) Priority: 22.12.86 US 945351

(43) Date of publication of application:
06.07.88 Bulletin 88/27

(84) Designated Contracting States:
DE FR GB

(71) Applicant: Zsamboky, Kalman F.
14900 County Road 79
Elk River Minnesota 55330(US)

(72) Inventor: Zsamboky, Kalman F.
14900 County Road 79
Elk River Minnesota 55330(US)

(74) Representative: Schwan, Gerhard, Dipl.-Ing.
Elfenstrasse 32
D-8000 München 83(DE)

(54) A method of improving bond strength between a metal layer and a non-metallic substrate.

(57) A method of improving the bond strength between a plated metal layer and a non-metallic ceramic substrate. The method comprises the steps of: baking the substrate to remove any organic compounds on or within the substrate and any holes or indentations therein, plating a layer of metal, such as copper, on the substrate, and firing the substrate at a temperature slightly above the eutectic point of the metal to cause a strong bond to be formed between the metal layer and the ceramic substrate.

EP 0 273 227 A2

# A METHOD OF IMPROVING BOND STRENGTH BETWEEN A METAL LAYER AND A NON-METALLIC SUBSTRATE

## BACKGROUND OF THE INVENTION

### 1. Field of the Invention.

This invention discloses a method of improving the bond strength between a deposited metal and a non-metallic substrate, and in particular, a method of improving the bond strength between a deposited copper layer and a ceramic substrate for the production of electronic circuits.

### 2. Description of the Prior Art.

In order to make electronic circuits such as printed circuit assemblies and hybrid circuits, a substrate is typically provided with a conductive metal layer from which metallized conductor patterns can be formed. By coating the substrate with the metal, such as copper, plating with other metals, such as nickel or gold, can follow.

In order to produce hybrid circuits, a ceramic substrate is often used. Typically, the ceramic substrate is provided with a thin layer of copper using electroless copper deposition techniques in which copper is plated or deposited on the substrate using chemical means. The ceramic substrate may be exposed to a number of chemical solutions, including an activator solution containing, for example, palladium. The palladium activator allows the copper in the electroless bath to be deposited in a layer on the substrate. The copper may then be etched to form the desired patterns and traces for the electric circuit.

One of the problems with this and other methods of attaching a copper layer to the ceramic substrate is that poor adhesion of the metal layer to the substrate often results. This can result in circuit patterns or traces which peel from the substrate when pulled with a minimum amount of force or lift from the ceramic when the circuit is in use, especially in high humidity and thermal cycling applications. Peeling of traces becomes a greater problem as the traces become finer, due to the decreased bond area.

United States Patent No. 3,994,430 to Cusano et al. shows a method for direct bonding of metal sheets to ceramics and other metals. In Cusano, a method of bonding is disclosed in which a bonding agent forms a eutectic alloy with the sheet of metal to provide bonding to the substrate. In general, a relatively thin sheet of metal, such as copper, is cut into a workpiece having the desired circuit pattern.

A controlled amount of bonding agent is introduced onto the substrate or the workpiece, and the metal workpiece is positioned on the substrate. Thereafter, the metal workpiece and the substrate are heated in a nitrogen furnace to a temperature between the eutectic temperature and the melting point of the metal for a time sufficient to form a eutectic melt between the metal workpiece and the substrate. Upon cooling and resolidification of the metal, the bond is formed.

In order to obtain well-adhered copper foil without blisters using the method of Cusano: (1) the copper sheet must be carefully oxidized to a black surface; (2) the copper oxide thickness must be carefully controlled; (3) the amount of oxygen in the copper sheet must be controlled; (4) the oxygen content of the nitrogen furnace must be maintained at a controlled level to maintain a very moderately oxidizing atmosphere; and (5) the temperature must be controlled within a very small range. Therefore, this method is difficult and expensive to operate and control.

Another disadvantage with the method of Cusano is that it will not metalize holes extending through the substrate, such as are found in many hybrid circuit applications. Although the surface of the ceramic can be covered with metal, the Cusano method does not provide for the placement of metal on the walls of holes which have been machined into or through the substrate, which are often needed to complete electrical interconnections in hybrid and multilayer circuits.

A third disadvantage with the method of Cusano is that when placing the metal sheet on the ceramic, gases may be entrapped under the sheet due to the presence of such gases in the pores of the ceramic. These entrapped gases may expand when the substrate undergoes the heating necessary to form the bond, thus causing bubbles or blisters under the metal sheet. These defects can seriously interfere with the performance of the circuit, since the traces can peel from the substrate. In addition, the blisters can cause short circuits or open circuits, especially when very thin lines and spaces are used in the circuit.

The problems due to entrapped gases and blistering also limit the amount of surface area which can be covered using the method of Cusano. For example, the blistering problem is more acute when a relatively large area is covered with metal and often requires that small holes be placed in the metal workpiece to allow for the escape of these gases during heating. However, a metal layer with small holes will not function in some applications, such as in microwave shields.

A fourth disadvantage with the method described in Cusano is that in order to handle and process the metal layer into the desired configuration, the metal must be quite thick. Although Cusano states that 1 mil thick copper can be bonded, this is probably too thin to be easily handled, especially when cut into the desired patterns. The minimum thickness copper which can be processed and bonded using the method of Cusano is probably approximately 3 mils. In the present method, very thin layers of metal may be deposited and bonded to the substrate.

Another patent relating to the direct bonding of metal sheets to non-metallic substrates is U.S. Patent No. 3,766,634 to Babcock et al. Babcock also discloses a method of placing a metal member on a non-metallic substrate and heating, although no bonding agent is utilized. This method suffers from many of the same problems as Cusano, including lack of through-hole coverage, entrapment of gases under the metal and limitations on the thinness of metal layers which can be efficiently handled and processed.

## SUMMARY OF THE INVENTION

The present invention is a method of improving the bond strength between a deposited metal layer and a non-metallic substrate. The method comprises the steps of: baking the substrate to remove any organic compounds on or within the substrate or any holes or indentations therein, depositing a layer of metal, such as copper, on the surface of the substrate and in the holes, and firing the substrate at a temperature slightly above the eutectic point of the metal to cause an oxygen double bond to be formed between the metal layer and the ceramic substrate.

## DETAILED DESCRIPTION OF THE PREFERRED EMBODIMENTS

The present invention is a method of improving the bond strength between a deposited metal, such as copper, and a non-metallic substrate, such as ceramic.

In typical hybrid circuit manufacturing techniques, a conductive layer of metal is deposited on a ceramic substrate. This substrate may also be referred to as a blank. Examples of ceramic substrates include: aluminum oxide, alumina, beryllium oxide, beryllium titanate and ferrite or other substrates having similar characteristics. In addition, a product sold by the Corning Glass Works (New York) under the name Photoceran may be used as a substrate.

It is necessary that the substrate be able to survive the eutectic temperature of the metal for the required firing time as discussed below without adversely affecting the substrate quality. For example, the substrate must be able to withstand the eutectic temperature without flowing, blistering or breaking. In addition, the substrate must contain alumina oxide ($Al_2O_3$) for proper bonding of the metal.

The alumina oxide in the substrate may be present in either random or crystal form. The substrates described above are examples of random-form alumina oxide. Sapphire is an example of a crystal form of the substrate which can be used as a substrate in the present method. For example, synthetic optical grade sapphire can be metallized and processed in accordance with the present invention to produce electronic circuits.

In order to configure the ceramic blank as required for the final electronic circuit, the blank is machined with a laser or other suitable means to produce the desired lines, holes or other surface characteristics. Holes which extend through the substrate are often required to complete electrical connections between the circuit traces or the layers in a multilayered circuit, or to allow connections to be made to other electrical components.

After the ceramic blank has been machined as desired, it is heated in a kiln or other suitable heating device to a temperature of 925°C (1697°F). This temperature is maintained for thirty to forty minutes in order to bake contaminants, such as organic compounds, from the substrate. Thereafter, the blank is allowed to cool slowly in the kiln to room temperature. This process may take a full day.

Next, a layer of metal, such as copper or nickel, is plated on the surface of the substrate and on the walls of any holes which have been made in the ceramic substrate. This layer of copper may be plated using any of a number of either electroless and electrolytic techniques. One such method is the method described in the co-pending application entitled Method of Metallizing Ceramic Substrates, Serial No. 889,678, filed July 24, 1986 by the same inventor, which is hereby incorporated by reference herein.

In that method, the substrate is first heated to remove surface contaminants. The surface is then etched with an acid etchant and exposed to an alkaline solution containing an activator such as palladium. The surface exposed to the activator is then processed in an electroless bath to deposit a thin layer of metal, such as copper, on the surface. Typically, the copper is deposited to a thickness of approximately 0.5 mil on the substrate. Additional layers of copper may be either electrolessly deposited or electroplated onto the metal by conventional means. This method produces an electrolessly deposited layer of metal on the ceramic substrate.

Another method of applying a layer of copper is disclosed in U.S. Patent No. 4,574,094 to De-Luca et al. Generally, DeLuca discloses a process for producing a printed circuit on a ceramic substrate by first treating the ceramic surface with a melt comprising one or more alkali metal compounds to etch the surface or promote adhesion. The surface is next exposed to an adsorption promoter to promote adsorption of catalyst on the surface and to eliminate bare spots in an adherent metal layer formed on the surface. The ceramic surface which was exposed to the adsorption promoter is then treated with a catalyst for the electroless deposition of metal. Thereafter, the printed circuit pattern is imposed on the substrate by conventional printed circuit methods.

Another method of depositing metal on the substrate comprises the steps of baking the ceramic blank to remove any surface contaminants, and dipping the blank into a concentrated palladium solution containing approximately 2 grams of palladium per liter. The substrate is then allowed to air dry and then is baked in an oven at approximately 450°C for one hour. This baked substrate is then processed in an electroless copper solution to deposit copper on the surface. Electroplated copper containing no brightners is then applied to the substrate, which may be fired according to the present invention.

After the copper metal has been deposited on the surface of the ceramic substrate by the above methods or similar methods, an average pull strength of approximately ten to fifteen pounds per 100 mil pad results. The pull strength is an indication of the amount of force required to separate a metal area or "pad" from the ceramic substrate and is typically measured using a dynamometer or other suitable force gauge.

In accordance with the present invention, after the metal layer has been deposited on the substrate, the substrate is fired in an oven which subjects the substrate and the deposited copper layer to temperatures near the eutectic point of the metal.

As used herein, the term eutectic temperature means the temperature at which a mixture of the atoms of the metal layer and the ceramic substrate will melt. This temperature is generally slightly below the melting temperature of the pure metal itself. For example, the eutectic temperature of copper is between approximately 1066°C and 1075°C (1950°F and 1967°F), while the melting temperature of copper is approximately 1083°C (1981°F). At these eutectic temperatures, the copper oxide bonds the copper atoms in the deposited copper layer with the oxygen atoms of the aluminum oxide of the substrate.

In order to fire the substrate to achieve the temperature near the eutectic point of the metal, the ceramic substrate is fired in a furnace or other suitable heating device. For example, an electric flow-through hybrid furnace which has a top temperature of approximately 1100°C and a rate of travel of approximately six inches per minute over a twenty-seven foot length of furnace may be used. Using this furnace, the ceramic substrate is exposed to the top furnace temperature for approximately 3 minutes. Of course, thicker layers of copper require longer periods of time to reach the eutectic temperature and thus would need to be subjected to the top furnace temperatures for a longer period of time. After being fired in the furnace, the substrate is then allowed to cool for further processing by conventional methods.

The furnace utilizes a cover gas which is essentially nitrogen gas, or other gases which are nonreactive with oxygen, such a helium. In addition, oxygen in a concentration of approximately ten to fifty parts per million (ppm) plus may be added to the furnace in order to form a copper oxide layer if the part to be fired has not already oxidized. Generally, the amount of oxygen required is directly related to the thickness of the copper layer. For example, 0.1 mil copper requires approximately 10 ppm of oxygen while 1.0 mil copper requires 50 ppm of of oxygen. This required oxygen may be supplied by introducing oxygen gas into the furnace at a controlled rate, depositing a metal oxide layer before firing by screening or similar method, or oxidizing the part in the furnace.

After the substrate and metal are fired and allowed to cool, a strong bond is formed between the deposited metal layer and the substrate. For example, the pull strength of the copper layer processed may be double or greater than the pull strength of the unfired copper layer. For example, a 100 mil pad according to the method of the present invention has been determined to have a pull strength of between 20 and 30 pounds per 100 mil pad. It has also been shown in tests that a 100 mil copper pad on 25 mil thick ceramic substrate will result in the substrate shattering before the copper can be pulled from the substrate.

Although the present invention has been described with reference to the preferred embodiments, workers skilled in the art may recognize that changes may be made in form and detail without departing from the spirit and scope of the invention.

**Claims**

1. A method for increasing the bond strength between a metal and a non-metallic substrate, comprising the steps of

plating a layer of metal on the substrate; and

firing the substrate and the metal layer at approximately the eutectic temperature of the metal to form a bond between the metal and the substrate.

2. The method of claim 1 wherein the substrate comprises alumina oxide.

3. The method of claim 1 wherein the substrate is ceramic.

4. The method of claim 1 wherein the plated metal is copper.

5. The method of claim 1 wherein the metal is nickel.

6. The method of clam 4 wherein the metal is fired between approximately 1066°C and 1075°C.

7. The method of claim 1 wherein the substrate and metal are fired in a furnace.

8. The method of claim 1 wherein the substrate and metal are fired in the presence of oxygen.

9. An improved method of increasing the bond strength of a layer of metal plated on a non-metallic substrate, the improvement comprising the step of:

firing the substrate and the plated metal at approximately the eutectic temperature of the metal.

10. A method of increasing the bond strength between a metal and a non-metal substrate, comprising the steps of:

baking the substrate to remove contaminents;

plating a layer of metal on the substrate; and

firing the substrate and metal layer at approximately the eutectic temperature of the metal.

11. The method of claim 11 wherein the substrate is ceramic.

12. The method of claim 11 wherein the substrate is baked at approximately 925°C for 30 to 40 minutes.

13. The method of claim 11 wherein the metal is copper.

14. The method of claim 11 wherein the metal is deposited using electroless metal deposition techniques.

15. The method of claim 11 wherein the substrate and metal are fired between approximately 1066°C and 1075°C.

16. The method of claim 11 wherein the substrate and metal are fired in the presence of oxygen.